# EUROPÄISCHE PATENTSCHRIFT

(11) **EP 3 482 165 B1**
(45) Veröffentlichungstag und Bekanntmachung des Hinweises auf die Patenterteilung: **03.11.2021**
(21) Anmeldenummer: 17732450.6
(22) Anmeldetag: 26.06.2017
(51) Int. Cl.: G01F 1/684, G01F 15/14, B22F 7/08, B22F 3/22, H01C 1/036, G01F 1/69

(54) **VERFAHREN ZUR HERSTELLUNG EINES SENSORS EINES THERMISCHEN DURCHFLUSSMESSGERÄTS ZUR MESSUNG DES MASSEDURCHFLUSSES EINES MEDIUMS IN EINEM MESSROHR UND EIN SENSOR**
METHOD FOR PRODUCING A SENSOR OF A THERMAL FLOW METER FOR MEASURING THE MASS FLOW RATE OF A MEDIUM IN A MEASUREMENT TUBE, AND SENSOR
PROCÉDÉ DE PRODUCTION D'UN CAPTEUR D'UN DÉBITMÈTRE THERMIQUE SERVANT À MESURER UN DÉBIT MASSIQUE D'UN FLUIDE DANS UN TUBE DE MESURE ET CAPTEUR

(30) Priorität: 07.07.2016 DE 102016112496
(43) Veröffentlichungstag der Anmeldung: 15.05.2019
(73) Patentinhaber: Endress+Hauser Flowtec AG, 4153 Reinach (CH)
(72) Erfinder: SCHULTHEIS, Hanno, 3274 Hermrigen (CH); GRÜN, Alexander, 79539 Lörrach (DE); GABERTHÜEL, Stephan, 4104 Oberwil (CH)
(74) Vertreter: Andres, Angelika Maria
(86) Internationale Anmeldenummer: PCT/EP2017/065644
(87) Internationale Veröffentlichungsnummer: WO 2018/007181

(56) Entgegenhaltungen:
- WO-A1-2015/140182
- DE-A1-102007 042 789
- GB-A- 1 440 393
- BULGER M: "Metal injection molding", ADVANCED MATERIALS & PROCES, AMERICA SOCIETY FOR METALS. METALS PARK, OHIO, US, Bd. 163, Nr. 3, März 2005 (2005-03), Seiten 39-40, XP009100518, ISSN: 0882-7958

## Beschreibung

Die Erfindung betrifft ein Verfahren zur Herstellung eines Sensors eines thermischen Durchflussmessgeräts und einen Sensor.

Sensoren zur Messung eines Massestroms werden seit langer Zeit im Wesentlichen auf zwei verschiedene Arten eingesetzt. In einem Fall wird eine Temperaturdifferenz zwischen zwei Sensoren in einem Massestrom konstant gehalten. In einem zweiten Fall wird durch ein oder mehrere aktive Sensorelemente in einen Massestrom eine Wärmemenge eingeführt, welche Wärmemenge stromabwärts durch ein oder mehrere passive Sensorelemente registriert werden, siehe beispielsweise die Offenlegungsschrift DE102009028848A1.

Sensoren weisen üblicherweise eine metallische Hülle auf, welche mit dem durch das Messrohr strömenden Medium in Kontakt tritt. Die metallische Hülle weist in ihrem Inneren ein Sensorelement auf, wobei für die Temperaturmessung häufig auf die Messung eines temperaturabhängigen Widerstands zurückgegriffen wird.

Der Stand der Technik umfasst Sensoren, bei denen ein Sensorkern in eine Hülle eingeführt wird, wobei die Hülle einen geringfügig größeren Innendurchmesser als der Außendurchmesser des Sensorkerns aufweist. In Folge dessen bestehen Probleme bei der Herstellung eines ausreichend guten thermischen Kontakts zwischen der metallischen Hülle und dem Sensorkern, wodurch der Einsatz einer Vergussmasse notwendig wird.

Eine Möglichkeit auf den Einsatz einer Vergussmasse zu verzichten entsteht dadurch, dass die Metallhülle durch Einwirken eines hohen Außendrucks auf den Sensorkern gepresst wird. So kann ein ausreichend guter thermischer Kontakt hergestellt werden. Beispielsweise zeigt die Offenlegungsschrift US5880365A einen Sensor, bei dem eine metallische Hülle durch Hydroforming auf ein Sensorkern gepresst wird. Jedoch besteht bei dieser Herstellungsmethode die Gefahr, dass sich die Pressung während des Pressvorgangs ungleichmäßig ausbildet und somit das Sensorelement aufgrund ungleichmäßiger mechanischer Belastung beschädigt.

Der Stand der Technik kann auch durch die Dokumente DE 10 2007 042 789 oder WO 2015/140182 A1 dargestellt werden.

Aufgabe der Erfindung ist es daher ein Verfahren zur Herstellung eines Sensors eines thermischen Durchflussmessgeräts und einen Sensor vorzuschlagen, bei welchem auf den Einsatz einer Vergussmasse verzichtet werden kann und das Risiko einer Beschädigung während der Herstellung minimiert ist.

Die Aufgabe wird erfindungsgemäß gelöst durch ein Verfahren gemäß dem unabhängigen Anspruch 1 und durch einen Sensor gemäß dem unabhängigen Anspruch 7.

Das erfindungsgemäße Verfahren zur Herstellung eines Sensors weist dabei folgende Verfahrensschritte auf:
Herstellen einer metallischen Ummantelung mittels eines
Metallpulverspritzgußverfahrens, wobei die Ummantelung mindestens ein erstes Sackloch aufweist, wobei ein erstes Ende der Ummantelung offen ist, und wobei ein zweites Ende der Ummantelung geschlossen ist;
Einbringen eines Sensorkerns in das erste Sackloch der metallischen Ummantelung durch das erste Ende, wobei die Ummantelung den Sensorkern vollständig umfasst;
Sintern der metallischen Ummantelung,
wobei der Sensorkern umfasst:
   mindestens einen keramischen Kern, welcher mindestens eine Mantelfläche aufweist;
   und mindestens einen metallischen Draht, welcher um die Mantelfläche des keramischen Kerns herumgewickelt ist;
   und mindestens eine elektrisch isolierende Schicht, welche dazu eingerichtet ist, den metallischen Draht von der metallischen Ummantelung elektrisch zu isolieren, wobei nach Sintern der Sensorkern durch die Ummantelung festgehalten ist.

In einer Ausgestaltung des Verfahrens schrumpft die Ummantelung durch das Sintern, wobei der Querschnitt des ersten Sacklochs vor Sintern der Ummantelung größer ist als der Querschnitt des Sensorkerns, und wobei nach Sintern der Ummantelung der Querschnitt des ersten Sacklochs gleich dem Querschnitt des Sensorkerns ist, und wobei die Ummantelung nach dem Sintern den Sensorkern vollständig umfasst und einen thermischen Kontakt zum Sensorkern herstellt.

In einer Ausgestaltung des Verfahrens weist das Metallpulver zur Herstellung der Ummantelung mittels eines Metallpulverspritzgußverfahrens eine Korngröße kleiner als 6 Mikrometer, und insbesondere kleiner als 4 Mikrometer und bevorzugt kleiner als 2 Mikrometer auf. Die Korngröße hat einen starken Einfluss auf die Dichtheit und Festigkeit der gesinterten metallischen Ummantelung, je kleiner die Korngröße desto dichter und desto stärker wirkt sich die Kohäsion zwischen einzelnen Körnern der metallischen Ummantelung aus. Es hat sich gezeigt, dass ab einer Korngröße von 6 Mikrometern und kleiner eine ausreichende Dichtheit und Stabilität der metallischen Ummantelung gegeben ist.

In einer Ausgestaltung des Verfahrens nimmt das Volumen der Ummantelung durch das Sintern nach Einsetzen des Sensorkerns weniger als 40% und insbesondere weniger als 30% und bevorzugt weniger als 20% ab.

In einer Ausgestaltung des Verfahrens weist der keramische Kern eine hohlzylindrische Struktur mit einem offenen dritten Ende und einem offenen vierten Ende auf, wobei der metallische Draht durch das vierte Ende zum dritten Ende geführt ist,
und wobei das dritte Ende des keramischen Kerns zum offenen ersten Ende der Ummantelung zeigt und wobei das vierte Ende des keramischen Kerns zum geschlossenen zweiten Ende der Ummantelung zeigt.

In einer Ausgestaltung des Verfahrens weist der keramische Kern eine hohlzylindrische Struktur mit einem zweiten Sackloch und einem offenen dritten Ende und einem fünften Ende auf, wobei der keramische Kern des Weiteren im Bereich des fünften Endes eine radiale Bohrung zum zweiten Sackloch aufweist, wobei der metallische Draht durch die radiale Bohrung zum dritten Ende geführt ist,
und wobei das dritte Ende des keramischen Kerns zum offenen ersten Ende der Ummantelung zeigt und wobei das fünfte Ende des keramischen Kerns zum geschlossenen zweiten Ende der Ummantelung zeigt. Das fünfte Ende kann dabei offen oder geschlossen sein.

Ein erfindungsgemäßer Sensor zur Messung des Massedurchflusses eines Mediums in einem Messrohr mittels eines thermischen Durchflussmessgeräts umfasst dabei:
mindestens eine metallische Ummantelung, wobei die Ummantelung mindestens ein erstes Sackloch aufweist, wobei ein erstes Ende der Ummantelung offen ist, und wobei ein zweites Ende der Ummantelung geschlossen ist;
und mindestens einen Sensorkern mit mindestens einen keramischen Kern, welcher mindestens eine Mantelfläche aufweist, und mit mindestens einen metallischen Draht, welcher um die Mantelfläche des keramischen Kerns herumgewickelt ist;
wobei der Sensorkern in das erste Sackloch eingebracht ist, so dass die Ummantelung den Sensorkern vollständig umfasst;
wobei der Sensorkern mindestens eine elektrisch isolierende Schicht aufweist, welche dazu eingerichtet ist, den metallischen Draht von der metallischen Ummantelung elektrisch zu isolieren.

In einer Ausgestaltung des Sensors weist die Wicklung mindestens 10 und insbesondere mindestens 30 und bevorzugt mindestens 50 Windungen auf. Idealerweise ist der Draht im Bereich der Wicklung eng gewunden, so dass eine Widerstandskonzentration in einem kleinen Bereich des Sensorkerns stattfindet. Der Draht kann zumindest im Bereich der Wicklung eine isolierende Schicht aufweisen, so dass im Bereich der Wicklung die Windungen seitlichen Kontakt annehmen können, ohne einen elektrischen Kurzschluss zwischen den Windungen herzustellen.

In einer Ausgestaltung des Sensors ist die elektrisch isolierende Schicht ein keramisches Pulver oder eine keramische Paste.

In einer Ausgestaltung des Sensors ist der keramische Kern ein Hohlzylinder und weist ein offenes drittes Ende und ein offenes viertes Ende auf, wobei der metallische Draht durch das vierte Ende zum dritten Ende geführt ist,
und wobei das dritte Ende des keramischen Kerns zum offenen ersten Ende der Ummantelung zeigt und wobei das vierte Ende des keramischen Kerns zum geschlossenen zweiten Ende der Ummantelung zeigt.

In einer Ausgestaltung des Sensors weist der keramische Kern eine hohlzylindrische Struktur mit einem zweiten Sackloch und einem offenen dritten Ende und einem fünften Ende auf, wobei der keramische Kern des Weiteren im Bereich des fünften Endes eine radiale Bohrung zum zweiten Sackloch aufweist, wobei der metallische Draht durch die radiale Bohrung zum dritten Ende geführt ist,
und wobei das dritte Ende des keramischen Kerns zum offenen ersten Ende der Ummantelung zeigt und wobei das fünfte Ende des keramischen Kerns zum geschlossenen zweiten Ende der Ummantelung zeigt. Das fünfte Ende kann dabei offen oder geschlossen sein.

In einer Ausgestaltung des Sensors ist der Draht aus einem Metall oder einer Legierung mit einer Schmelztemperatur größer als 1300 °C und insbesondere größer als 1500 °C und bevorzugt größer als 1800 °C wie beispielsweise Platin oder Wolfram oder Tantal gefertigt.

In einer Ausgestaltung des Sensors ist der Durchmesser des Drahts im Bereich der Wicklung kleiner als 0.3 mm und insbesondere kleiner als 0.1 mm und bevorzugt kleiner als 0.05 mm. Durch einen verkleinerten Drahtdurchmesser im Bereich der Wicklung kann der Widerstand im Bereich der Wicklung im Vergleich zum restlichen Draht weiter erhöht werden, so dass eine weitere Widerstandskonzentration im Bereich der Wicklung erreicht wird.

In einer Ausgestaltung des Sensors ist der äußere Durchmesser des keramischen Kerns kleiner als 5 mm und insbesondere kleiner als 4 mm und bevorzugt kleiner als 2.5 mm.

In einer Ausgestaltung des Sensors weist der keramische Kern eine Längsachse auf, wobei die Länge des keramischen Kerns entlang der Längsachse mindestens 3 mm und bevorzugt mindestens 5 mm und insbesondere mindestens 10 mm und höchstens 100 mm und insbesondere höchstens 60 mm und bevorzugt höchstens 30 mm ist.

In einer Ausgestaltung des Sensors ist die Wicklung im Bereich des vierten Endes angeordnet und weist entlang der Längsachse eine Ausdehnung von höchstens 7 mm und bevorzugt höchstens 5 mm und insbesondere höchstens 3 mm auf. Durch eine kleine Ausdehnung des Wicklungsbereichs lässt sich die Temperatur des Medium punktuell auslesen.

In einer Ausgestaltung des Sensors ist die Wandstärke der Ummantelung mindestens 0.05 mm und insbesondere mindestens 0.1 mm und bevorzugt mindestens 0.15 mm und höchstens 1 mm und insbesondere höchstens 0.6 mm und bevorzugt höchstens 0.3 mm.

Es werden also durch die vorliegende Erfindung ein Verfahren zur Herstellung eines Sensors eines thermischen Durchflussmessgeräts zur Messung des Massedurchflusses eines Mediums in einem Messrohr und ein Sensor eines thermischen Durchflussmessgeräts vorgeschlagen.

Im Folgenden wird die Erfindung anhand von Ausführungsbeispielen erläutert.
Fig. 1 zeigt einen schematischen Verfahrensablauf zum Herstellen eines erfindungsgemäßen Temperatursensors.
Fig. 2 zeigt einen schematischen Querschnitt durch eine erfindungsgemäße metallische Ummantelung mit Sensorkern vor und nach dem Sintern.
Fig. 3a zeigt einen schematischen Querschnitt durch einen erfindungsgemäßen Sensorkern gemäß einer ersten Ausführungsform.
Fig. 3b zeigt einen schematischen Querschnitt durch einen erfindungsgemäßen Sensorkern gemäß einer zweiten Ausführungsform.

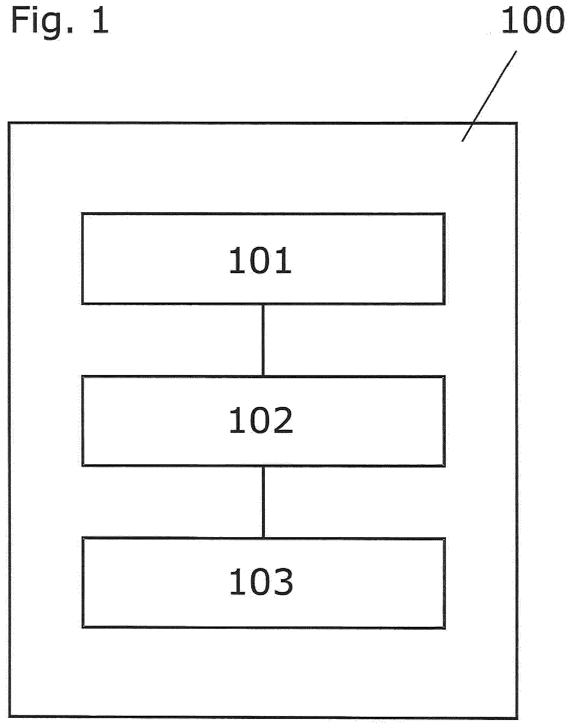

Fig. 1 zeigt eine Ausführungsform des Verfahrensablaufs 100 zum Herstellen eines erfindungsgemäßen Temperatursensors. In einem ersten Schritt 101 wird dabei eine metallische Ummantelung 10 für einen Sensorkern 50, 51 eines Sensors 60 für ein thermisches Durchflussmessgerät mittels eines Metallpulverspritzgußverfahrens hergestellt. In einem zweiten Schritt 102 wird der Sensorkern 50, 51 in die metallische Ummantelung 10 eingebracht. Durch Sintern der metallischen Ummantelung 10 in einem dritten Schritt 103 mit eingebrachtem Sensorkern 50, 51 schrumpft die metallische Ummantelung 10 bis sie den Sensorkern 50, 51 fest hält und einen guten thermischen Kontakt sicherstellt. Der Sensorkern lässt sich dabei erst durch Zugkräfte von mindestens 1N von der metallischen Ummantelung 10 lösen.

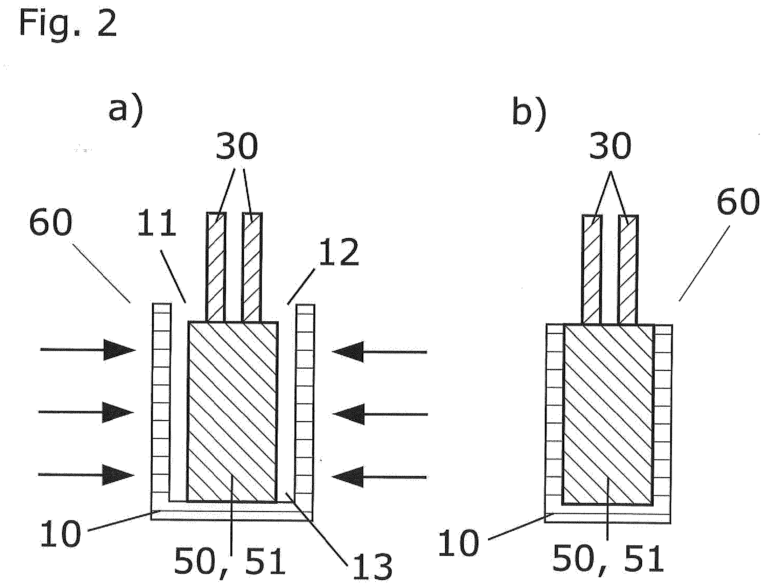

Fig. 2 zeigt eine Ausführungsform den Sensor 60 vor und nach dem Sintern. Fig. 2a zeigt den Sensor 60 vor dem Sintern, wobei die metallische Ummantelung 10 den Sensorkern 50, 51 vollständig umfasst aber nicht festhält. Ein Draht 30 wird dabei durch ein offenes erstes Ende 12 der metallischen Ummantelung 10, welche ein Sackloch 11 ausbildet geführt und zu einer Betriebselektronik geführt, welche Betriebselektronik dazu eingerichtet ist, den Sensor 60 zu betreiben. Idealerweise ist der Sensorkern 50, 51 bei Beginn des Sinterns in Kontakt mit einem geschlossenen zweiten Ende 13 der metallischen Ummantelung 10. Durch Sintern schrumpft die metallische Ummantelung 10, bis der Innendurchmesser der metallischen Ummantelung die Größe des Außendurchmessers des Sensorkerns 60 annimmt, siehe Fig. 2b.

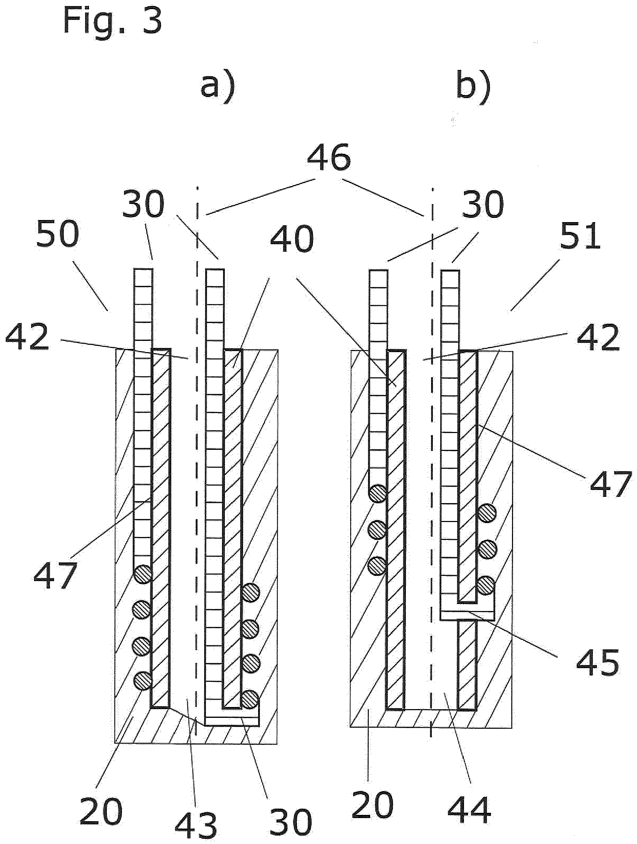

Fig. 3 zeigt schematisch zwei erfindungsgemäße Ausführungsformen des Sensorkerns 50, 51. Fig. 3a zeigt einen Sensorkern 50 mit einem keramischen Kern 40 mit einer Mantelfläche 47. Der keramische Kern 40 weist eine hohlzylindrische Struktur mit einem offenen dritten Ende 42 und mit einem offenen vierten Ende 43 auf, wobei der metallische Draht 30 von der Mantelfläche 47 durch das vierte Ende 43 zum dritten Ende 42 geführt ist. Fig. 3a zeigt einen Sensorkern 51, dessen keramischer Kern 40 im Gegensatz zur in Fig. 3a gezeigten Ausführungsform im Bereich des fünften Endes 44 eine Bohrung 45 aufweist, durch welche Bohrung 45 der Draht 30 von der Mantelfläche zum offenen dritten Ende 42 geführt wird. Das fünfte Ende 42 kann dabei auch ein geschlossenes Ende sein. Die Wicklung des Drahts 30 um die Mantelfläche 47 des keramischen Kerns 50, 51 konzentriert sich dabei in beiden Ausführungsformen auf einen begrenzten Bereich, um eine Widerstandskonzentration innerhalb des Bereichs zu bewirken. Der Sensor 60 lässt sich auf mehrere Arten und Weisen betreiben.

Einerseits kann er zum Erwärmen eines ihn umströmenden Mediums verwendet werden, andererseits kann er zum Messen der Temperatur des Mediums und/oder des Sensors verwendet werden. In allen Fällen ist eine Widerstandskonzentration auf einen begrenzten Bereich vorteilhaft. Der Sensorkern 50, 51 weist eine elektrisch isolierende Schicht 20 auf, welche den Draht 30 von der metallischen Ummantelung 10 elektrisch isoliert, wobei die elektrisch isolierende Schicht 20 ein keramisches Pulver oder eine keramische Paste ist.

**Bezugszeichenliste**

| | |
|---|---|
| Metallische Ummantelung | 10 |
| Erstes Sackloch | 11 |
| Erstes Ende | 12 |
| Zweites Ende | 13 |
| Elektrisch isolierende Schicht | 20 |
| Draht | 30 |
| Keramischer Kern | 40 |
| Drittes Ende | 42 |
| Viertes Ende | 43 |
| Fünftes Ende | 44 |
| Radiale Bohrung | 45 |
| Längsachse | 46 |
| Mantelfläche | 47 |
| Sensorkern | 50, 51 |
| Sensor | 60 |

## Patentansprüche

1. Verfahren zur Herstellung eines Sensors (60) eines thermischen Durchflussmessgeräts zur Messung des Massedurchflusses eines Mediums in einem Messrohr,
wobei das Verfahren folgende Verfahrensschritte aufweist:
Herstellen einer metallischen Ummantelung (10) mittels eines
Metallpulverspritzgußverfahrens, wobei die Ummantelung mindestens ein erstes Sackloch (11) aufweist, wobei ein erstes Ende (12) der Ummantelung offen ist, und wobei ein zweites Ende (13) der Ummantelung geschlossen ist;
Einbringen eines Sensorkerns (50, 51) in das erste Sackloch (11) der metallischen Ummantelung (10) durch das erste Ende (12), wobei die Ummantelung (10) den Sensorkern (50, 51) vollständig umfasst;
Sintern der metallischen Ummantelung (10),
wobei der Sensorkern (50, 51) umfasst: mindestens einen keramischen Kern (40), welcher mindestens eine Mantelfläche (47) aufweist;
und mindestens einen metallischen Draht (30), welcher um die Mantelfläche (47) des keramischen Kerns (40) herumgewickelt ist;
und mindestens eine elektrisch isolierende Schicht (20), welche dazu eingerichtet ist, den metallischen Draht (30) von der metallischen Ummantelung (10) elektrisch zu isolieren,
wobei nach Sintern der Sensorkern durch die Ummantelung festgehalten ist.

2. Verfahren nach Anspruch 1,
wobei die Ummantelung (10) durch das Sintern schrumpft, wobei der Querschnitt des ersten Sacklochs (11) vor Sintern der Ummantelung (10) größer ist als der Querschnitt des Sensorkerns (50, 51), und wobei nach Sintern der Ummantelung (10) der Querschnitt des ersten Sacklochs (11) gleich dem Querschnitt des Sensorkerns ist (50, 51), und wobei die Ummantelung (10) nach dem Sintern den Sensorkern (50, 51) vollständig umfasst und einen thermischen Kontakt zum Sensorkern (50, 51) herstellt.

3. Verfahren nach mindestens einem der vorigen Ansprüche,
wobei ein Metallpulver zur Herstellung der Ummantelung (10) mittels eines Metallpulverspritzgußverfahrens eine Korngröße kleiner als 6 Mikrometer, und insbesondere kleiner als 4 Mikrometer und bevorzugt kleiner als 2 Mikrometer aufweist.

4. Verfahren nach mindestens einem der vorigen Ansprüche 2 bis 3,
wobei das Volumen der Ummantelung (10) durch das Sintern nach Einsetzen des Sensorkerns (50, 51) weniger als 40% und insbesondere weniger als 30% und bevorzugt weniger als 20% abnimmt.

5. Verfahren nach mindestens einem der vorigen Ansprüche,
wobei der keramische Kern (40) eine hohlzylindrische Struktur mit einem offenen dritten Ende (42) und einem offenen vierten Ende (43) aufweist, wobei der metallische Draht (30) durch das vierte Ende (43) zum dritten Ende (42) geführt ist, und wobei das dritte Ende (42) des keramischen Kerns (40) zum offenen ersten Ende (12) der Ummantelung (10) zeigt und wobei das vierte Ende (43) des keramischen Kerns (40) zum geschlossenen zweiten Ende (13) der Ummantelung (10) zeigt.

6. Verfahren nach mindestens einem der vorigen Ansprüche 1 bis 5,
wobei der keramische Kern (40) eine hohlzylindrische Struktur und einem offenen dritten Ende (42) und einem fünften Ende (44) aufweist, wobei der keramische Kern (40) des Weiteren im Bereich des fünften Endes (44) eine radiale Bohrung (45) aufweist, wobei der metallische Draht (30) durch die radiale Bohrung (45) zum dritten Ende (42) geführt ist,
und wobei das dritte Ende (42) des keramischen Kerns (40) zum offenen ersten Ende (12) der Ummantelung (10) zeigt und wobei das fünfte Ende (44) des keramischen Kerns (40) zum geschlossenen zweiten Ende (13) der Ummantelung (10) zeigt.

7. Sensor zur Messung des Massedurchflusses eines Mediums in einem Messrohr mittels eines thermischen Durchflussmessgeräts nach mindestens einem der vorhergehenden Ansprüche,
wobei der Sensor umfasst:
mindestens eine metallische Ummantelung (10), wobei die Ummantelung (10) mindestens ein erstes Sackloch (11) aufweist, wobei ein erstes Ende (12) der Ummantelung (10) offen ist, und wobei ein zweites Ende (13) der Ummantelung (10) geschlossen ist;
und mindestens einen Sensorkern (50, 51) mit mindestens einen keramischen Kern (40), welcher mindestens eine Mantelfläche (47) aufweist, und mit mindestens einen metallischen Draht (30), welcher um die Mantelfläche (47) des keramischen Kerns (40) herumgewickelt ist;
wobei der Sensorkern (50, 51) in das erste Sackloch (11) eingebracht ist, so dass die Ummantelung (10) den Sensorkern (50, 51) vollständig umfasst;
wobei der Sensorkern (50, 51) mindestens eine elektrisch isolierende Schicht (20) aufweist, welche dazu eingerichtet ist, den metallischen Draht (30) von der metallischen Ummantelung (10) elektrisch zu isolieren.

8. Sensor nach Anspruch 7,
wobei eine Wicklung mindestens 10 und insbesondere mindestens 30 und bevorzugt mindestens 50 Windungen aufweist.

9. Sensor nach Anspruch 7 oder 8,
wobei die elektrisch isolierende Schicht (20) ein keramisches Pulver oder eine keramische Paste ist.

10. Sensor nach mindestens einem der Ansprüche 7 bis 9,
wobei der keramische Kern (40) ein Hohlzylinder ist und ein offenes drittes Ende (42) und ein offenes viertes Ende (43) aufweist, wobei der metallische Draht (30) durch das vierte Ende (43) zum dritten Ende (42) geführt ist,
und wobei das dritte Ende (42) des keramischen Kerns (40) zum offenen ersten Ende (12) der Ummantelung (10) zeigt und wobei das vierte Ende (43) des keramischen Kerns (40) zum geschlossenen zweiten Ende (13) der Ummantelung (10) zeigt.

11. Sensor nach mindestens einem der Ansprüche 7 bis 10,
wobei der keramische Kern (40) eine hohlzylindrische Struktur mit einem zweiten Sackloch (41) und einem offenen dritten Ende (42) und einem fünften Ende (44) aufweist, wobei der keramische Kern (40) des Weiteren im Bereich des fünften Endes (44) eine radiale Bohrung (45) zum zweiten Sackloch (41) aufweist, wobei der metallische Draht (30) durch die radiale Bohrung (45) zum dritten Ende (42) geführt ist,
und wobei das dritte Ende (42) des keramischen Kerns (40) zum offenen ersten Ende (12) der Ummantelung (10) zeigt und wobei das fünfte Ende (44) des keramischen Kerns (40) zum geschlossenen zweiten Ende (13) der Ummantelung (10) zeigt.

12. Sensor nach mindestens einem der Ansprüche 7 bis 11,
wobei der Draht (30) aus einem Metall oder einer Legierung mit einer Schmelztemperatur größer als 1300 °C und insbesondere größer als 1500 °C und bevorzugt größer als 1800 °C wie beispielsweise Platin oder Wolfram oder Tantal gefertigt ist.

13. Sensor nach mindestens einem der Ansprüche 7 bis 12,
wobei der Durchmesser des Drahts (30) im Bereich der Wicklung kleiner als 0.3 mm und insbesondere kleiner als 0.1 mm und bevorzugt kleiner als 0.05 mm ist.

14. Sensor nach mindestens einem der Ansprüche 7 bis 13,
wobei der äußere Durchmesser des keramischen Kerns (40) kleiner als 5 mm und insbesondere kleiner als 4 mm und bevorzugt kleiner als 2.5 mm ist.

15. Sensor nach mindestens einem der Ansprüche 7 bis 14,
wobei der keramische Kern (40) eine Längsachse (46) aufweist, und wobei die Länge des keramischen Kerns (40) entlang der Längsachse (46) mindestens 3 mm und bevorzugt mindestens 5 mm und insbesondere mindestens 10 mm und höchstens 100 mm und insbesondere höchstens 60 mm und bevorzugt höchstens 30 mm ist.

16. Sensor nach mindestens einem der Ansprüche 7 bis 15,
wobei die Wicklung im Bereich des vierten Endes (43) beziehungsweise fünften Endes (44) angeordnet ist und entlang der Längsachse (46) eine Ausdehnung von höchstens 7 mm und bevorzugt höchstens 5 mm und insbesondere höchstens 3 mm aufweist.

17. Sensor nach mindestens einem der Ansprüche 7 bis 16,
wobei die Wandstärke der Ummantelung (10) mindestens 0.05 mm und insbesondere mindestens 0.1 mm und bevorzugt mindestens 0.15 mm und höchstens 1 mm und insbesondere höchstens 0.6 mm und bevorzugt höchstens 0.3 mm ist.

## Claims

1. Procedure for the manufacture of a sensor (60) of a thermal flowmeter designed to measure the mass flow of a medium in a measuring tube,
wherein said procedure comprises the following steps:
Fabrication of a metal shielding (10) using a metal injection molding procedure, wherein
the shielding has at least a first blind hole (11), wherein a first end (12) of the shielding is open, and wherein a second end (13) of the shielding is closed;
Introduction of a sensor core (50, 51) into the first blind hole (11) of the metal shielding (10) through the first end (12), wherein the shielding (10) fully surrounds the sensor core (50, 51);
Sintering of the metal shielding (10),
wherein the sensor core (50, 51) comprises:
at least a ceramic core (40), which has at least a lateral surface (47); and at least a metal wire (30) which is wrapped around the lateral surface (47) of the ceramic core (40); and at least an electrically isolating layer (20) which is provided to electrically isolate the metal wire (30) in relation to the shielding (10),
wherein, after sintering, the sensor core is held in place by the shielding (10).

2. Procedure as claimed in Claim 1,
wherein the shielding (10) shrinks as a result of the sintering, wherein, before the shielding (10) is sintered, the cross-section of the first blind hole (11) is greater than the cross-section of the sensor core (50, 51) and wherein, after the shielding (10) is sintered, the cross-section of the first blind hole (11) is equal to the cross-section of the sensor core (50, 51), and wherein, after sintering, the shielding (10) fully surrounds the sensor core (50, 51) and establishes a thermal contact to the sensor core (50, 51).

3. Procedure as claimed in at least one of the previous claims,
wherein a metal powder used for the production of the shielding (10) by means of a metal injection molding procedure has a grain size less than 6 micrometers, and particularly less than 4 micrometers and preferably less than 2 micrometers.

4. Procedure as claimed in at least one of the previous Claims 2 to 3,
wherein, following the introduction of the sensor core (50, 51), the volume of the shielding (10) is reduced by the sintering by less than 40 % and particularly by less than 30 % and preferably by less than 20 %.

5. Procedure as claimed in at least one of the previous claims,
wherein the ceramic core (40) has a hollow cylindrical structure with an open third end (42) and an open fourth end (43), wherein the metal wire (30) runs through the fourth end (43) to the third end (42), and wherein the third end (42) of the ceramic core (40) points towards the open first end (12) of the shielding (10) and wherein the fourth end (43) of the ceramic core (40) points towards the closed second end (13) of the shielding (10).

6. Procedure as claimed in at least one of the previous Claims 1 to 5,
wherein the ceramic core (40) has a hollow cylindrical structure and an open third end (42) and a fifth end (44), wherein the ceramic core (40) additionally has a radial borehole (45) in the area of the fifth end (44), wherein the metal wire (30) is guided through the radial borehole (45) to the third end (42), and wherein the third end (42) of the ceramic core (40) points towards the open first end (12) of the shielding (10) and wherein the fifth end (44) of the ceramic core (40) points towards the closed second end (13) of the shielding (10).

7. Sensor designed to measure the mass flow of a medium in a measuring tube by means of a thermal flowmeter as claimed in at least one of the previous claims,
said sensor comprising:
at least a metal shielding (10), wherein said shielding (10) has at least a first blind hole (11), wherein a first end (12) of said shielding (10) is open, and a second end (13) of said shielding (10) is closed;
and at least a sensor core (50, 51) with at least a ceramic core (40), said core having at least a lateral surface (47) and at least a metal wire (30) wrapped around the lateral surface (47) of the ceramic core (40);
wherein the sensor core (50, 51) is introduced into the first blind hole (11) in such a way that the shielding (10) completely surrounds the sensor core (50, 51);
wherein the sensor core (50, 51) has at least an electrically isolating layer (20), which is provided to electrically isolate the metal wire (30) in relation to the metal shielding (10).

8. Sensor as claimed in Claim 7,
wherein a coil has at least 10, particularly at least 30 and preferably at least 50 windings.

9. Sensor as claimed in Claim 7 or 8,
wherein the electrically isolating layer (20) is a ceramic powder or a ceramic paste.

10. Sensor as claimed in at least one of the Claims 7 to 9,
wherein the ceramic core (40) is a hollow cylinder and has an open third end (42) and an open fourth end (43), wherein the metal wire (30) runs through the fourth end (43) to the third end (42),
and wherein the third end (42) of the ceramic core (40) points towards the open first end (12) of the shielding (10) and wherein the fourth end (43) of the ceramic core (40) points towards the closed second end (13) of the shielding (10).

11. Sensor as claimed in at least one of the Claims 7 to 10,
wherein the ceramic core (40) has a hollow cylindrical structure with a second blind hole (41) and an open third end (42) and a fifth end (44), wherein the ceramic core (40) additionally has a radial borehole (45) towards the second blind hole (41) in the area of the fifth end (44), wherein the metal wire (30) runs through the radial borehole (45) to the third end (42),
and wherein the third end (42) of the ceramic core (40) points towards the open first end (12) of the shielding (10) and wherein the fifth end (44) of the ceramic core (40) points towards the closed second end (13) of the shielding (10).

12. Sensor as claimed in at least one of the Claims 7 to 11,
wherein the wire (30) is made from a metal or an alloy having a melting temperature greater than 1300 °C and particularly greater than 1500 °C and preferably greater than 1800 °C, such as platinum or tungsten or tantalum for example.

13. Sensor as claimed in at least one of the Claims 7 to 12,
wherein the diameter of the wire (30) in the area of the winding is less than 0.3 mm and particularly less than 0.1 mm and preferably less than 0.05 mm.

14. Sensor as claimed in at least one of the Claims 7 to 13,
wherein the outer diameter of the ceramic core (40) is less than 5 mm and particularly less than 4 mm and preferably less than 2.5 mm.

15. Sensor as claimed in at least one of the Claims 7 to 14,
wherein the ceramic core (40) has a longitudinal axis (46), and wherein the length of the ceramic core (40) along the longitudinal axis (46) is at least 3 mm and preferably at least 5 mm and particularly at least 10 mm and at most 100 mm and particularly at most 60 mm and preferably at most 30 mm.

16. Sensor as claimed in at least one of the Claims 7 to 15,
wherein the winding is arranged in the area of the fourth end (43) or of the fifth end (44) and has an extension along the longitudinal axis (46) of at most 7 mm and preferably at most 5 mm and particularly at most 3 mm.

17. Sensor as claimed in at least one of the Claims 7 to 16,
wherein the wall thickness of the shielding (10) is at least 0.05 mm and particularly at least 0.1 mm and preferably at least 0.15 mm and at most 1 mm and particularly at most 0.6 mm and preferably at most 0.3 mm.

## Revendications

1. Procédé destiné à la fabrication d'un capteur (60) d'un débitmètre thermique destiné à la mesure du débit massique d'un produit dans un tube de mesure,
lequel procédé comprend les étapes suivantes :
Fabrication d'une enveloppe métallique (10) au moyen d'un procédé de moulage par injection de poudre métallique, l'enveloppe présentant au moins un premier trou borgne (11), une première extrémité (12) de l'enveloppe étant ouverte, et une deuxième extrémité (13) de l'enveloppe étant fermée ;
Insertion d'un noyau de capteur (50, 51) dans le premier trou borgne (11) de l'enveloppe métallique (10) à travers la première extrémité (12), l'enveloppe (10) entourant complètement le noyau de capteur (50, 51) ;
Frittage de l'enveloppe métallique (10),
le noyau de capteur (50, 51) comprenant :
au moins un noyau céramique (40), lequel présente au moins une surface latérale (47) ; et au moins un fil métallique (30) enroulé autour de la surface latérale (47) du noyau céramique (40) ;
et au moins une couche électriquement isolante (20) prévue pour isoler électriquement le fil métallique (30) par rapport à l'enveloppe (10),
le noyau de capteur étant maintenu en place, après frittage, par l'enveloppe (10).

2. Procédé selon la revendication 1,
pour lequel l'enveloppe (10) se rétrécit par frittage, la section transversale du premier trou borgne (11), avant frittage de l'enveloppe (10), étant plus grande que la section transversale du noyau de capteur (50, 51) et, après frittage de l'enveloppe (10), la section transversale du premier trou borgne (11) étant égale à la section transversale du noyau de capteur (50, 51), et l'enveloppe (10), après frittage, entourant complètement le noyau de capteur (50, 51) et établissant un contact thermique avec le noyau de capteur (50, 51).

3. Procédé selon au moins l'une des revendications précédentes,
pour lequel une poudre métallique pour la fabrication de l'enveloppe (10) au moyen d'un procédé de moulage par injection de poudre métallique présente une taille de grain inférieure à 6 micromètres, et notamment inférieure à 4 micromètres et de préférence inférieure à 2 micromètres.

4. Procédé selon au moins l'une des revendications précédentes 2 à 3,
pour lequel le volume de l'enveloppe (10) diminue par frittage après insertion du noyau de capteur (50, 51) de moins de 40 % et notamment de moins de 30 % et de préférence de moins de 20 %.

5. Procédé selon au moins l'une des revendications précédentes,
pour lequel le noyau céramique (40) présente une structure cylindrique creuse avec une troisième extrémité ouverte (42) et une quatrième extrémité ouverte (43), le fil métallique (30) étant guidé à travers la quatrième extrémité (43) jusqu'à la troisième extrémité (42), et la troisième extrémité (42) du noyau céramique (40) faisant face à la première extrémité ouverte (12) de l'enveloppe (10) et la quatrième extrémité (43) du noyau céramique (40) faisant face à la deuxième extrémité fermée (13) de l'enveloppe (10).

6. Procédé selon au moins l'une des revendications précédentes 1 à 5,
pour lequel le noyau céramique (40) présente une structure cylindrique creuse et une troisième extrémité ouverte (42) et une cinquième extrémité (44), le noyau céramique (40) présentant en outre un orifice radial (45) dans la zone de la cinquième extrémité (44), le fil métallique (30) étant guidé à travers l'orifice radial (45) jusqu'à la troisième extrémité (42), et la troisième extrémité (42) du noyau céramique (40) faisant face à la première extrémité ouverte (12) de l'enveloppe (10) et la cinquième extrémité (44) du noyau céramique (40) faisant face à la deuxième extrémité fermée (13) de l'enveloppe (10).

7. Capteur destiné à la mesure du débit massique d'un produit dans un tube de mesure au moyen d'un débitmètre thermique selon au moins l'une des revendications précédentes, lequel capteur comprend :
au moins une enveloppe métallique (10), ladite enveloppe (10) présentant au moins un premier trou borgne (11), une première extrémité (12) de ladite enveloppe (10) étant ouverte, et une deuxième extrémité (13) de ladite enveloppe (10) étant fermée ;
et au moins un noyau de capteur (50, 51) comprenant au moins un noyau céramique (40), lequel noyau présente au moins une surface de revêtement (47) et au moins un fil métallique (30) enroulé autour de la surface de revêtement (47) du noyau céramique (40) ;
le noyau de capteur (50, 51) étant inséré dans le premier trou borgne (11) de sorte que l'enveloppe (10) entoure complètement le noyau de capteur (50, 51) ;
le noyau de capteur (50, 51) présentant au moins une couche électriquement isolante (20), laquelle couche est prévue pour isoler électriquement le fil métallique (30) par rapport à l'enveloppe métallique (10).

8. Capteur selon la revendication 7,
pour lequel un enroulement comporte au moins 10, notamment au moins 30 et de préférence au moins 50 spires.

9. Capteur selon la revendication 7 ou 8,
pour lequel la couche électriquement isolante (20) est une poudre céramique ou une pâte céramique.

10. Capteur selon au moins l'une des revendications 7 à 9,
pour lequel le noyau céramique (40) est un cylindre creux et présente une troisième extrémité ouverte (42) et une quatrième extrémité ouverte (43), le fil métallique (30) étant guidé à travers la quatrième extrémité (43) jusqu'à la troisième extrémité (42),
et la troisième extrémité (42) du noyau céramique (40) faisant face à la première extrémité ouverte (12) de l'enveloppe (10) et la quatrième extrémité (43) du noyau céramique (40) faisant face à la deuxième extrémité fermée (13) de l'enveloppe (10).

11. Capteur selon au moins l'une des revendications 7 à 10,
pour lequel le noyau céramique (40) présente une structure cylindrique creuse avec un deuxième trou borgne (41) et une troisième extrémité ouverte (42) et une cinquième extrémité (44), le noyau céramique (40) présentant en outre un orifice radial (45) vers le deuxième trou borgne (41) dans la zone de la cinquième extrémité (44), le fil métallique (30) étant guidé à travers l'orifice radial (45) jusqu'à la troisième extrémité (42),
et la troisième extrémité (42) du noyau céramique (40) faisant face à la première extrémité ouverte (12) de l'enveloppe (10) et la cinquième extrémité (44) du noyau céramique (40) faisant face à la deuxième extrémité fermée (13) de l'enveloppe (10).

12. Capteur selon l'une au moins l'une des revendications 7 à 11,
pour lequel le fil (30) est constitué d'un métal ou d'un alliage présentant une température de fusion supérieure à 1 300 °C et notamment supérieure à 1 500 °C et de préférence supérieure à 1 800 °C, comme par exemple le platine ou le tungstène ou le tantale.

13. Capteur selon l'une au moins l'une des revendications 7 à 12,
pour lequel le diamètre du fil (30) dans la zone de l'enroulement est inférieur à 0,3 mm et
notamment inférieur à 0,1 mm et de préférence inférieur à 0,05 mm.

14. Capteur selon l'une au moins l'une des revendications 7 à 13,
pour lequel le diamètre extérieur du noyau céramique (40) est inférieur à 5 mm et notamment inférieur à 4 mm et de préférence inférieur à 2,5 mm.

15. Capteur selon l'une au moins l'une des revendications 7 à 14,
pour lequel le noyau céramique (40) présente un axe longitudinal (46), et la longueur du noyau céramique (40) selon l'axe longitudinal (46) étant d'au moins 3 mm et de préférence d'au moins 5 mm et notamment d'au moins 10 mm et d'au plus 100 mm et notamment d'au plus 60 mm et de préférence d'au plus 30 mm.

16. Capteur selon l'une au moins l'une des revendications 7 à 15,
pour lequel l'enroulement est disposé dans la zone de la quatrième extrémité (43) ou de la cinquième extrémité (44) et présente une extension le long de l'axe longitudinal (46) d'au plus 7 mm et de préférence d'au plus 5 mm et notamment d'au plus 3 mm.

17. Capteur selon l'une au moins l'une des revendications 7 à 16,
pour lequel l'épaisseur de paroi de l'enveloppe (10) est d'au moins 0,05 mm et notamment d'au moins 0,1 mm et de préférence d'au moins 0,15 mm et d'au plus 1 mm et notamment d'au plus 0,6 mm et de préférence d'au plus 0,3 mm.
